# EUROPEAN PATENT APPLICATION

(11) **EP 2 647 684 A1**
(43) Date of publication of application: **09.10.2013**
(21) Application number: 11845169.9
(22) Date of filing: 28.11.2011
(51) Int. Cl.: C09J 175/06, C09J 11/06, H01L 31/042

(54) **URETHANE ADHESIVE FOR OUTDOOR USE**

(30) Priority: 29.11.2010 JP 2010265365
(71) Applicant: Henkel Japan Ltd., Tokyo 140-0002 (JP); Henkel AG & Co. KGaA, 40589 Düsseldorf (DE)
(72) Inventor: MATSUKI, Yuichi, Minoo-shi Osaka 562-8586 (JP); YOSHIDA, Yoshio, Minoo-shi Osaka 562-8586 (JP); HAYAKAWA, Tadashi, Minoo-shi Osaka 562-8586 (JP)
(74) Representative: Stromberg, Christian
(86) International application number: PCT/JP2011/077316
(87) International publication number: WO 2012/073859

(57) **Abstract**

Provided are a urethane adhesive for outdoor use which has high peel strength and excellent weatherability, a solar-cell back sheet obtained using the adhesive, and a solar-cell module obtained using the solar-cell back sheet. The urethane adhesive for outdoor use comprises (A) a urethane resin obtained by reacting one or more isocyanate compounds (a1) with a polyol (a2) having an ester bond and (B) a hydroxyphenyltriazine compound, the isocyanate compounds (a1) comprising at least one compound selected from aliphatic isocyanates and alicyclic isocyanates. The adhesive has high peel strength and excellent weatherability. The urethane resin for outdoor use which further contains a silane compound is more preferable.

## Description

### Technical Field

The present invention relates to an outdoor urethane adhesive. More particularly, the present invention relates to a solar battery back sheet obtainable by using the adhesive, and a solar battery module obtainable by using the solar battery back sheet.

### Background Art

Outdoor materials such as barrier materials, roof materials, solar battery panel materials, window materials, outdoor flooring materials, illumination protective materials, automobile members and signboards include, as a constituent material, a laminate obtainable by laminating plural films using an adhesive. Examples of the films constituting the laminate include metal foils, metal plates and metal deposited films of aluminum, copper, steel and the like; plastic films of polypropylene, polyvinyl chloride, polyester, fluorine resin, acrylic resin and the like; and so on.

Since these laminates are exposed to UV light over a long period, excellent weatherability is required of the outdoor adhesive. A higher level of weatherability than that of a conventional outdoor adhesive is especially required of an adhesive for a solar battery which converts sunlight into electric power.

The practical use of solar batteries as useful energy resources has made progress. Such solar batteries include various known types, such as silicon-based solar batteries, compound-based solar batteries, organic solar batteries and the like.

In these solar batteries, a surface protective sheet is commonly provided on a surface on which sunlight falls for the purpose of protecting that surface. A rear protective sheet (back sheet) is also provided on a surface opposite to the surface on which sunlight falls for the purpose of protecting a solar battery cell.

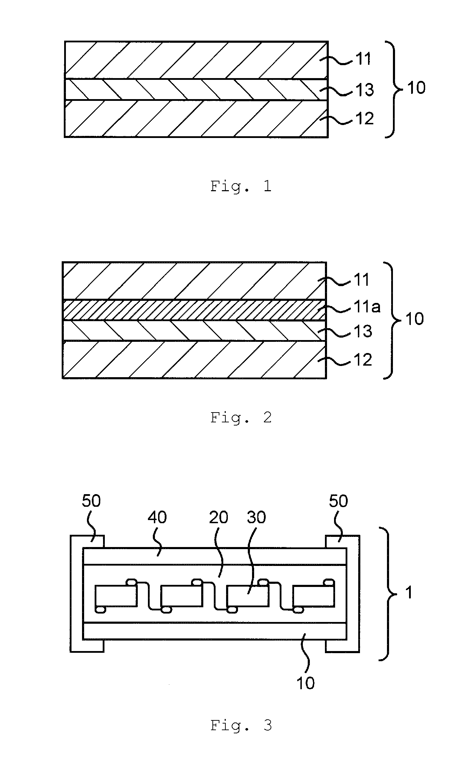

As shown in Fig. 1, a back sheet 10 is a laminate of plural films 11 and 12, and the films 11 and 12 are laminated (or pasted) by interposing an adhesive 13 therebetween. The back sheet 10 constitutes a solar battery module 1, together with a sealing material 20, a solar battery cell 30 and a glass plate 40 (see Fig. 3).

Since the solar battery module 1 is exposed to sunlight over a long time, sufficient durability and weatherability are required. Particularly, when the adhesive 13 has low performances, the films 11 and 12 are peeled and thus the appearance of the laminated back sheet 10 is impaired. Therefore, it is required that the adhesive for solar battery back sheets does not result in peeling of the film even if the back sheet is exposed over the long period.

Patent Documents 1 and 2 disclose that a urethane based adhesive is used as an adhesive for solar battery back sheets (see, for example, Claim 1 of Patent Document 1, paragraph 0037 of Patent Document 2, etc.). The urethane based adhesive is known as an adhesive for mutually bonding films. However, it is hard to say that the urethane based adhesive has enough durability to be used as a solar battery back sheet which is exposed outdoors over a long period.

Patent Document 3 discloses an outdoor urethane-based adhesive with durability improved by using a specific polyester polyol (see CLAIMS, [0014], etc. of Patent Document 3). The Patent Document discloses that the hydrolysis resistance of the urethane adhesive is improved by using a specific polyester polyol as an adhesive raw material, and thus obtaining an adhesive which is effective for use in a solar battery back sheet (see [0070] to [0072] of Patent Document 3).

However, since a high level of durability is required of the solar battery back sheet, a high level of weatherability is also required of the urethane adhesive. Furthermore, progress has recently been made in the development of an organic solar battery with lower production costs compared with solar batteries using silicon and an inorganic compound material. Since the organic solar battery has a feature that it can be colored and also can have flexibility, a transparent film may be employed as a film constituting the solar battery back sheet. Therefore, it is required for the adhesive for solar battery back sheets to maintain peel strength over a long time, and also to cause little change in color difference and to have remarkably excellent weatherability.

### Prior Art Document

### Patent Document

Patent Document 1: JP2008-004691A
Patent Document 2: JP2009-248377A
Patent Document 3: JP4416047B

### Disclosure of the Invention

### Problems to be Solved by the Invention

The present invention has been made so as to solve these problems and an object thereof is to provide an outdoor urethane adhesive which has high peel strength and is also excellent in weatherability; a solar battery back sheet obtainable by using the adhesive; and a solar battery module obtainable by using the solar battery back sheet.

### Means for Solving the Problems

The present inventors have intensively studied and found, surprisingly, that it is possible to obtain an outdoor urethane adhesive having both remarkably improved adhesive strength and weatherability by using a specific polyol and a specific isocyanate compound as raw materials of the urethane resin, and adding a specific ultraviolet absorber, and thus the present invention has been completed.

Namely, the present invention provides, in a first aspect, an outdoor urethane adhesive comprising:
(A) a urethane resin obtainable by reacting an isocyanate compound (a1) with a polyol having an ester bond (a2), and
(B) a hydroxyphenyltriazine based compound, wherein
   the isocyanate compound (a1) comprises at least one selected from an aliphatic isocyanate and an alicyclic isocyanate.

The present invention provides, in an embodiment, an outdoor urethane adhesive, wherein the polyol (a2) comprises at least one selected from a polyester polyol and an acrylic polyol.
The present invention provides, in another embodiment, an outdoor urethane adhesive, further comprising a silane compound.

The present invention provides, in a preferred embodiment, an outdoor urethane adhesive, further comprising a hindered phenol based compound.
The present invention provides, in a further embodiment, an outdoor urethane adhesive, further comprising a hindered amine based compound.

The present invention provides, in another aspect, a solar battery back sheet obtainable by using the outdoor urethane adhesive.
The present invention provides, in a preferred aspect, a solar battery module obtainable by using the solar battery back sheet.

### Effects of the Invention

The outdoor urethane adhesive according to the present invention comprises:
(A) a urethane resin obtainable by reacting an isocyanate compound (a1) with a polyol having an ester bond (a2), and
(B) a hydroxyphenyltriazine based compound, wherein
   the isocyanate compound (a1) comprises at least one selected from an aliphatic isocyanate and an alicyclic isocyanate.
Therefore, both performances of peel strength and weatherability are improved, and thus the adhesive is suited for use as an adhesive for solar battery back sheets. Particularly, since colorability and flexibility are required of an organic solar battery back sheet, the outdoor urethane adhesive of the present invention is more preferable as an adhesive for organic solar battery back sheets.

When the polyol (a2) comprises at least one selected from a polyester polyol and an acrylic polyol, since any one of the polyester polyol and the acrylic polyol is contained, and thus an outdoor urethane adhesive having further improved peel strength is obtainable.

Furthermore, the outdoor urethane adhesive of the present invention further contains a silane compound, whereby, the peel strength is improved and also the weatherability is more improved, and thus an adhesive which is more suitable as an adhesive for solar battery back sheets is obtainable.
The outdoor urethane adhesive of the present invention further contains a hindered phenol based compound, whereby, the weatherability is more improved, and thus an adhesive which is more suitable as an adhesive for solar battery back sheets is obtainable. The outdoor urethane adhesive of the present invention further contains a hindered amine based compound, whereby, the weatherability is more improved due to a synergistic effect with hydroxyphenyltriazine, and thus the obtained adhesive can be more preferably used as an adhesive for solar battery back sheets.

Since the solar battery back sheet according to the present invention is obtained by using the above outdoor urethane adhesive, even if the back sheet is exposed outsides over a long period, a film is not peeled as a result of degradation of the adhesive, and the film does not undergo discoloration.
An organic solar battery using an organic compound in a light absorption layer has recently been developed, and it is required for the organic solar battery to have colorability and flexibility. Therefore, since a film constituting the back sheet of the organic solar battery is apt to become transparent, the solar battery back sheet of the present invention, which causes little change in color difference and flexibility, is useful from such a point of view.
Since the solar battery module according to the present invention is obtained by using the solar battery back sheet, it is excellent in appearance and is also excellent in durability.

### Brief Description of the Drawings

Fig. 1 is a sectional view showing an embodiment of the solar battery back sheet of the present invention.
Fig. 2 is a sectional view showing another embodiment of the solar battery back sheet of the present invention.
Fig. 3 is a sectional view showing an embodiment of the solar battery module of the present invention.

### Embodiments for Carrying Out the Invention

The outdoor urethane adhesive according to the present invention contains (A) a urethane resin, and (B) a hydroxyphenyltriazine based compound.
The urethane resin in the present invention (A) is a polymer obtainable by reacting an isocyanate compound (a1) with a polyol having an ester bond (a2), and has a urethane bond.

The isocyanate compound (a1) comprises at least one selected from an aliphatic isocyanate and an alicyclic isocyanate, and is not particularly limited as long as the objective outdoor urethane adhesive of the present invention can be obtained.
The "isocyanate compound (a1)" according to the present invention does not mean that it is composed of only the aliphatic isocyanate and the alicyclic isocyanate. As long as the objective outdoor urethane adhesive of the present invention is obtained, in other words, as long as an adverse influence is not exerted on peel strength and weatherability of the outdoor urethane adhesive of the present invention, the isocyanate compound (a1) may contain an aromatic isocyanate. The isocyanate compound (a1) preferably contains no ethylenic double bond (for example, ethylene group, butylene group, etc.) from the viewpoint of weatherability.

In the present specification, as mentioned above, the isocyanate is classified into an aliphatic isocyanate, an alicyclic isocyanate and an aromatic isocyanate. The isocyanate compound (a1) as a feature of the present invention is not composed of only the aromatic isocyanate since it contains at least one selected from the aliphatic isocyanate and the alicyclic isocyanate.

In the present specification, the "aliphatic isocyanate" refers to a compound which has a chain-like (or linear) hydrocarbon chain in which the isocyanate group is directly connected to the hydrocarbon chain, and also has no cyclic hydrocarbon chain. Although the "aliphatic isocyanate" may have an aromatic ring, the aromatic ring is not directly connected to the isocyanate group.
In the present specification, the aromatic ring is not contained in the cyclic hydrocarbon chain.
The "alicyclic isocyanate" is a compound which has a cyclic hydrocarbon chain and may have a chain-like hydrocarbon chain. The isocyanate group may be either directly connected to the cyclic hydrocarbon chain, or may be directly connected to the chain-like hydrocarbon chain which may be had. Although the "alicyclic isocyanate" may have an aromatic ring, the aromatic ring is not directly connected to the isocyanate group.

The "aromatic isocyanate" refers to a compound which has an aromatic ring, in which the isocyanate group is directly connected to the aromatic ring. Therefore, a compound, in which the isocyanate group is not directly connected to the aromatic ring, is classified into the aliphatic isocyanate or the alicyclic isocyanate even if it contains the aromatic ring in the molecule.
Therefore, for example, 4,4'-diphenylmethane diisocyanate (OCN-C₆H₄-CH₂-C₆H₄-NCO) corresponds to the aromatic isocyanate since the isocyanate groups are directly connected to the aromatic ring. On the other hand, for example, xylylene diisocyanate (OCN-CH₂-C₆H₄-CH₂-NCO) corresponds to the aliphatic isocyanate since it has an aromatic ring, but the isocyanate groups are not directly connected to the aromatic ring and connected to methylene groups.
The aromatic ring may be fused with two or more benzene rings.

Examples of the aliphatic isocyanate include 1,4-diisocyanatobutane, 1,5-diisocyanatopentane, 1,6-diisocyanatohexane (hereinafter referred to as HDI), 1,6-diisocyanato-2,2,4-trimethylhexane, methyl 2,6-diisocyanatohexanoate (lysine diisocyanate), 1,3-bis(isocyanatomethyl)benzene (xylylene diisocyanate) and the like.
Examples of the alicyclic isocyanate include 5-isocyanato-1-isocyanatomethyl-1,3,3-trimethylcyclohexane (isophorone diisocyanate), 1,3-bis(isocyanatomethyl)cyclohexane (hydrogenated xylylene diisocyanate), bis(4-isocyanatocyclohexyl)methane (hydrogenated diphenylmethane diisocyanate), 1,4-diisocyanatocyclohexane and the like.

In the present invention, the isocyanate compound (a1) may contain the aromatic isocyanate as long as the objective urethane adhesive of the present invention can be obtained. Examples of the aromatic isocyanate include 4,4'-diphenylmethane diisocyanate, p-phenylenediisocyanate, m-phenylenediisocyanate and the like.
These isocyanate compounds can be used alone, or in combination. Particularly, HDI, isophorone diisocyanate and xylylene diisocyanate are preferable, and a trimer of HDI, a trimer of isophorone diisocyanate and a monomer of xylylene diisocyanate are particularly preferable.

In the present invention, the polyol having an ester bond (a2) contains any one of a polyester polyol and an acrylic polyol, and is not particularly limited as long as the objective outdoor urethane adhesive of the present invention can be obtained. The polyol (a2) having an ester bond preferably contain no ethylenic double bond from the viewpoint of weatherability.

In the present invention, the "polyester polyol" refers to a compound which is a "main-chain type" polyester and has an ester bond and a hydroxyl group in the "main chain". This hydroxyl group usually locates at the end of the main chain and functions as a functional group capable of reacting with the isocyanate group.
The polyester polyol is commonly obtained by the condensation polymerization reaction of a low-molecular polyol with a dicarboxylic acid and an anhydride thereof.

Examples of such a dicarboxylic acid include oxalic acid, malonic acid, succinic acid, glutaric acid, adipic acid, pimelic acid, suberic acid, azelaic acid, sebacic acid, dodecanedioic acid, 2-methylsuccinic acid, 2-methyladipic acid, 3-methyladipic acid, 3-methylpentanedioic acid, 2-methyloctanedioic acid, 3,8-dimethyldecanedioic acid, 3,7-dimethyldecanedioic acid, phthalic acid, terephthalic acid, isophthalic acid, naphthalenedicarboxylic acid, trimellitic acid, trimesic acid, cyclohexanedicarboxylic acid and the like. These dicarboxylic acids are used alone or in combination.
Examples of the carboxylic anhydride include acetic anhydride, propionic anhydride, succinic anhydride, maleic anhydride and phthalic anhydride. These carboxylic anhydrides may be used alone, or plural kinds of them may be used in combination.

The low-molecular polyol preferably has 1 to 3 functional groups, and particularly preferably contains a difunctional diol, so-called diol. These diols can be used alone or in combination.
Examples of the diol include low-molecular weight polyols such as ethylene glycol, 1-methylethylene glycol, 1-ethylethylene glycol, propylene glycol, butanediol, pentanediol, hexanediol, heptanediol, octanediol, nonanediol, decanediol, neopentyl glycol, 2-methyl-1,3-propanediol, cyclohexanedimethanol, 2,4-dimethyl-1,5-pentanediol and 2,4-dibutyl-1,5-pentanediol. At least one selected from ethylene glycol, butanediol, hexanediol, octanediol and decanediol is preferable.

In the present invention, the "acrylic polyol" refers to a compound which is obtained by the addition polymerization reaction of a (meth)acrylate having a hydroxyl group, and has an ester bond in the "side chain".
The "acrylic polyol" may be either a homopolymer of a (meth)acrylate having a hydroxyl group, or a copolymer of the (meth)acrylate having a hydroxyl group with the "other polymerizable monomer". The hydroxyl group of the acrylic polyol reacts with the isocyanate group.
Examples of the "(meth)acrylate having a hydroxyl group" include 2-hydroxyethyl (meth)acrylate, 2-hydroxypropyl (meth)acrylate, 3-hydroxypropyl (meth)acrylate, glycerin mono(meth)acrylate, 4-hydroxybutyl acrylate and the like.

The "other polymerizable monomer" is a "radical polymerizable monomer having an ethylenic double bond" other than the "(meth)acrylate having a hydroxyl group". Specific examples thereof include (meth)acrylic acid, methyl (meth)acrylate, ethyl (meth)acrylate, butyl (meth)acrylate, cyclohexyl (meth)acrylate, 2-ethylhexyl (meth)acrylate, dicyclopentanyl (meth)acrylate, isobornyl (meth)acrylate, styrene and vinyltoluene and the like.

As long as the objective outdoor urethane adhesive of the present invention can be obtained, the polyol (a2) having an ester bond may contain a polyether polyol. Examples of the polyether polyol include polyoxytetramethylene glycol (PTMG), polyoxypropylene glycol (PPG), polyoxyethylene glycol (PEG) and the like.

The urethane resin (A) according to the present invention can be obtained by the reaction of the isocyanate compound (a1) with the polyol having an ester bond (a2). In the reaction, a known method can be used and the reaction can be usually performed by mixing the isocyanate compound (a1) with the polyol having an ester bond (a2). There is no particular limitation on the mixing method as long as the urethane resin (A) according to the present invention can be obtained.

In the present description, a "hydroxyphenyltriazine-based compound (B)" is a compound which is a kind of a triazine derivative in which a hydroxyphenyl derivative is combined with a carbon atom of a triazine derivative, which is commonly referred to a hydroxyphenyltriazine-based compound. There is no particular limitation on the hydroxyphenyltriazine-based compound as long as the objective outdoor urethane adhesive of the present invention can be obtained.

Examples of such a hydroxyphenyltriazine-based compound (B) preferably include, but are not limited to, compounds represented by the following formulas (1) to (5), and isomers thereof.

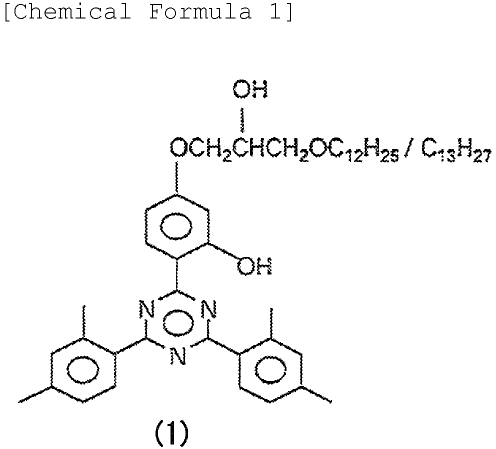

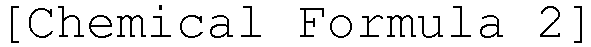

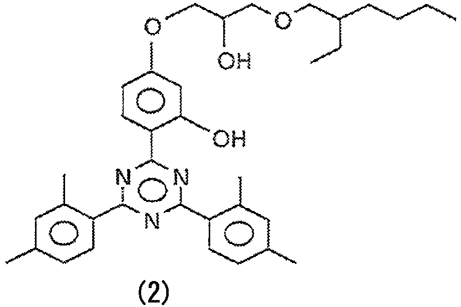

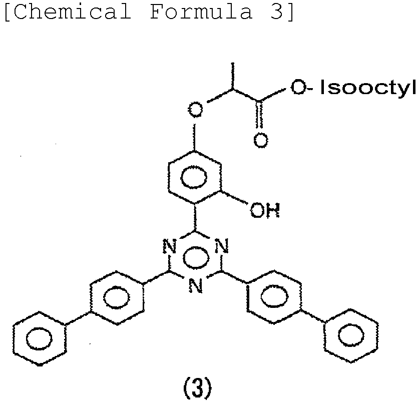

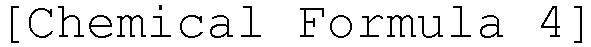

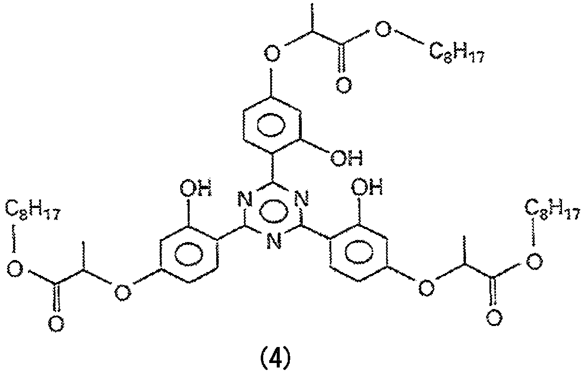

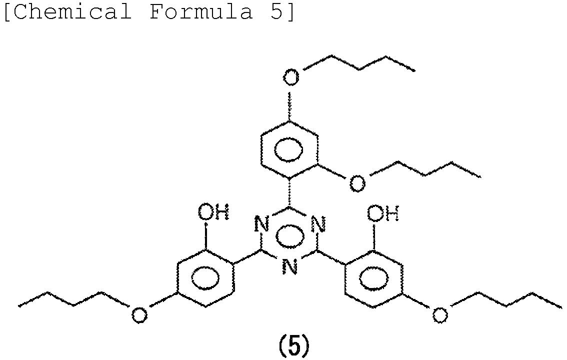

The hydroxyphenyltriazine-based compounds (B) of the chemical formulas (1) to (5) are commonly used as an ultraviolet absorber, and can be used in combination with other ultraviolet absorbers as long as the objective outdoor urethane adhesive of the present invention can be obtained. It is possible to use commercially available products as the hydroxyphenyltriazine based compound (B). For example, they are commercially available from BASF Corporation under the trade name of TINUVIN 400, TINUVIN 405, TINUVIN 479, TINUVIN 477 and TINUVIN 460.

The outdoor urethane adhesive of the present invention preferably contains a silane compound (C) in addition to the components (A) and (B).
In the present invention, it is possible to use, as the silane compound (C), for example, (meth)acryloxyalkyltrialkoxysilanes, (meth)acryloxyalkylalkylalkoxysilanes, vinyltrialkoxysilanes, vinylalkylalkoxysilanes, epoxysilanes, mercaptosilanes and isocyanuratesilanes. However, the silane compound is not limited to only these silane compounds.

Examples of the "(meth)acryloxyalkyltrialkoxysilanes" include 3-(meth)acryloxypropyltrimethoxysilane, 3-(meth)acryloxypropyltriethoxysilane, 4-(meth)acryloxyethyltrimethoxysilane and the like.
Examples of the "(meth)acryloxyalkylalkylalkoxysilanes" include 3-(meth)acryloxypropylmethyldimethoxysilane, 3-(meth)acryloxypropylmethyldiethoxysilane, 3-(meth)acryloxypropylethyldiethoxysilane, 3-(meth)acryloxyethylmethyldimethoxysilane and the like.
Examples of the "vinyltrialkoxysilanes" include vinyltrimethoxysilane, vinyltriethoxysilane, vinyldimethoxyethoxysilane, vinyltri(methoxyethoxy)silane, vinyltri(ethoxymethoxy)silane and the like.

Examples of the "vinylalkylalkoxysilanes" include vinylmethyldimethoxysilane, vinylethyldi(methoxyethoxy)silane, vinyldimethylmethoxysilane, vinyldiethyl(methoxyethoxy)silane and the like.
For example, the "epoxysilanes" can be classified into a glycidyl-based silane and an epoxycyclohexyl-based silane. The "glycidyl-based silanes" have a glycidoxy group, and specific examples thereof include 3-glycidoxypropylmethyldiisopropenoxysilane, 3-glycidoxypropyltrimethoxysilane, 3-glycidoxypropyltriethoxysilane, 3-glycidoxypropyldiethoxysilane and the like.
The "epoxycyclohexyl-based silanes" have a 3,4-epoxycyclohexyl group, and specific examples thereof include 2-(3,4-epoxycyclohexyl)ethyltrimethoxysilane, 2-(3,4-epoxycyclohexyl)ethyltriethoxysilane and the like.

Examples of the "mercaptosilanes" include 3-mercaptopropyltrimethoxysilane, 3-mercaptopropyltriethoxysilane and the like.
Examples of the "isocyanuratesilanes" include tris(3-(trimethoxysilyl)propyl)isocyanurate and the like.
These silane compounds (C) enables, in addition to an improvement in peel strength, an improvement in weatherability of an adhesive containing hydroxyphenyltriazine (B). In the present invention, it is particularly preferred that performances of the outdoor urethane adhesive are remarkably improved by the addition of the epoxysilanes.

It is preferred that the outdoor urethane adhesive of the present invention further contains at least one selected from a hindered phenol-based compound (D) and a hindered amine-based compound (E).
The "hindered phenol-based compound (D)" is commonly called a hindered phenol-based compound, and there is no particular limitation as long as the objective outdoor urethane adhesive of the present invention can be obtained.
It is possible to use, as the hindered phenol-based compound (D), commercially available products. For example, it is possible to use, as the hindered phenol-based compound (D), IRGANOX 1010, IRGANOX 1035, IRGANOX 1076, IRGANOX 1135, IRGANOX 1330, IRGANOX 1520 and the like. The hindered phenol-based compound is added to the adhesive as an antioxidant, and may also be used in combination with a phosphite-based antioxidant, a thioether-based antioxidant, an amine-based antioxidant and the like.

The "hindered amine-based compound (E)" is commonly called a hindered amine-based compound, and there is no particular limitation as long as the objective outdoor urethane adhesive of the present invention can be obtained.
It is possible to use, as the hindered amine-based compound (E), commercially available products. For example, it is possible to use, as the hindered amine-based compound (E), TINUVIN 765, TINUVIN 111FDL, TINUVIN 123, TINUVIN 144, TINUVIN 152, TINUVIN 292, TINUVIN 5100 and the like (all of which are trade names). The hindered amine-based compound is added to the adhesive as a photostabilizer, and may also be used in combination with a benzotriazole-based photostabilizer, a benzoate-based photostabilizer and the like.

The outdoor urethane adhesive according to the present invention can further contain the other components as long as the objective outdoor urethane adhesive can be obtained.
There is no particular limitation on timing of the addition of the "other components" to the outdoor urethane adhesive as long as the objective outdoor urethane resin of the present invention can be obtained. For example, the other components may be added together with the isocyanate compound (a1) and the polyol (a2) in synthesizing the urethane resin (A), or may be added together in adding the hydroxyphenyltriazine-based compound (B) after synthesizing the urethane resin (A) by the reaction of the isocyanate compound (a1) with the polyol (a2).

Examples of the "other components" include a tackifier, a pigment, a plasticizer, a flame retardant, a catalyst, a wax and the like.
Examples of the "tackifier" include a styrene-based resin, a terpene-based resin, aliphatic petroleum resin, an aromatic petroleum resin, a rosin ester, an acrylic resin, a polyester resin (excluding polyester polyol) and the like.
Examples of the "pigment" include titanium oxide, carbon black and the like.
Examples of the "plasticizer" include dioctyl phthalate, dibutyl phthalate, diisononyl adipate, dioctyl adipate, mineral spirit and the like.
Examples of the "flame retardant" include a halogen-based flame retardant, a phosphorous-based flame retardant, an antimony-based flame retardant and, a metal hydroxide-based flame retardant and the like.

Examples of the "catalyst" include metal catalysts such as tin catalysts (trimethyltin laurate, trimethyltin hydroxide, dibutyltin dilaurate, dibutyltin maleate, etc.), lead-based catalysts (lead oleate, lead naphthenate, lead octenate, etc.), and other metal catalysts (naphthenic acid metal salts such as cobalt naphthenate) and amine-based catalysts such as triethylenediamine, tetramethylethylenediamine, tetramethylhexylenediamine, diazabicycloalkenes, dialkylaminoalkylamines and the like.
The "wax" is preferably wax such as paraffin wax and microcrystalline wax.

The outdoor urethane adhesive of the present invention can be produced by mixing the above-mentioned components (A) and (B), and the optionally added components (C), (D) and (E), and the other components. There is no particular limitation on the mixing method as long as the objective outdoor urethane adhesive of the present invention can be obtained. There is also no particular limitation on the order of mixing the components. The outdoor urethane adhesive according to the present invention can be produced without requiring a special mixing method and a special mixing order. The obtained outdoor urethane adhesive is excellent in both adhesive strength and weatherability.
Therefore, the outdoor urethane adhesive is suited for outdoor materials such as barrier materials, roof materials, solar battery modules, window materials, outdoor flooring materials, illumination protective materials, automobile members and signboards. These outdoor materials include a laminate obtainable by laminating plural films. Examples of the films include a film (metal deposited film) in which metal is deposited on a plastic base material, and a film (plastic film) in which metal is not deposited.

It is required for an adhesive for producing solar battery modules - among the outdoor adhesives - to have excellent strength and a high level of weatherability. The outdoor urethane adhesive of the present invention is excellent in both peel strength and weatherability, and thus the adhesive is suited for an adhesive for solar battery back sheets.
In case of producing a solar battery back sheet, the outdoor urethane adhesive of the present invention is applied to a film. Application can be performed by various methods such as gravure coating, wire bar coating, air knife coating, die coating, lip coating and comma coating methods. Plural films coated with the outdoor urethane adhesive of the present invention are laminated with each other to obtain the solar battery back sheet.

An embodiment of the solar battery back sheet of the present invention is shown in Figs. 1 to 3, but the present invention is not limited to these embodiments. Fig. 1 is a sectional view of a solar battery back sheet of the present invention. A solar battery back sheet 10 is formed of two films and an outdoor urethane adhesive 13 interposed therebetween, and the two films 11 and 12 are laminated with each other by the outdoor urethane adhesive 13. The films 11 and 12 may be made of either the same or different material. In Fig. 1, the two films 11 and 12 are laminated with each other, or three or more films may be laminated with one another.

Another embodiment of a solar battery back sheet according to the present invention is shown in Fig. 2. In Fig. 2, a thin film 11a is formed between the film 11 and the outdoor urethane adhesive 13. For example, Fig. 2 shows an embodiment in which a metal thin film 11a is formed on a surface of a film 11 when the film 11 is a plastic film. The metal thin film 11a can be formed on the surface of the plastic film 11 by vapor deposition, and the solar battery back sheet of Fig. 2 can be obtained by laminating the film 12 to the film 11 having the metal thin film 11a formed thereon by interposing the outdoor urethane adhesive 13 therebetween.

Examples of the metal to be deposited on the plastic film include aluminum, steel, copper and the like. It is possible to impart barrier properties to the plastic film by subjecting the film to vapor deposition. Silicon oxide or aluminum oxide is used as a vapor deposition material. The plastic film 11 used as a base material may be either transparent, or white- or black-colored.
A plastic film made of polyvinyl chloride, polyester, a fluorine resin or an acrylic resin is useful as the film 12. In order to impart heat resistance and weatherability as well as rigidity, insulating properties and the like, a polyethylene terephthalate film or a polybutylene terephthalate film is preferably used. The films 11 and 12 may be either transparent or colored.
The film 12 and the deposited thin film 11a of the film 11 are laminated with each other using the outdoor urethane adhesive 13 of the present invention; the films 11 and 12 are often laminated with each other by a dry lamination method.

Fig. 3 shows a sectional view of an example of the solar battery module of the present invention. In Fig. 3, it is possible to obtain a solar battery module 1 of the present invention by overlaying a glass plate 40, a sealing material 20 such as an ethylene-vinyl acetate resin (EVA), plural solar battery cells 30 which are commonly connected with each other to generate a desired voltage, and a back sheet 10 onto one another, and then fixing these members 10, 20, 30 and 40 using a spacer 50.
As mentioned above, since the back sheet 10 is a laminate of the plural films 11 and 12, it is required for the urethane adhesive 13 to cause no peeling of the films 11 and 12 even if the back sheet 10 is exposed outdoors over a long period.

The solar battery cell 30 is often produced by using silicon, and is sometimes produced by using an organic resin containing a dye. In that case, the solar battery module 1 becomes an organic-based (dye-sensitization) solar battery module. Since colorability is required of the organic-based solar battery, a transparent film is often used as the films 11 and 12 which constitute the solar battery back sheet 10. Therefore, it is required for the outdoor urethane adhesive 13 to cause very little change in color difference even if the adhesive is exposed outdoors over a long period, and to have excellent weatherability.

Main embodiments of the present invention will be shown below.
1. An outdoor urethane adhesive comprising:
   (A) a urethane resin obtainable by reacting an isocyanate compound (a1) with a polyol having an ester bond (a2), and
   (B) a hydroxyphenyltriazine based compound, wherein the isocyanate compound (a1) comprises at least one selected from an aliphatic isocyanate and an alicyclic isocyanate.
2. The outdoor urethane adhesive according to the above 1, wherein the polyol (a2) comprises at least one selected from a polyester polyol and an acrylic polyol.
3. The outdoor urethane adhesive according to the above 1 or 2, the adhesive further comprises a silane compound.
4. The outdoor urethane adhesive according to any one of the above 1 to 3, the adhesive further comprises a hindered phenol based compound.
5. The outdoor urethane adhesive according to any one of the above 1 to 4, the adhesive further comprises a hindered amine based compound.
6. A solar battery back sheet obtainable by using the outdoor urethane adhesive according to any one of the above 1 to 5.
7. A solar battery module obtainable by using the solar battery back sheet according to the above 6.

### Examples

The present invention will be described below by way of Examples and Comparative Examples, and these Examples are merely for illustrative purposes and are not meant to be limiting on the present invention.
Raw materials for the outdoor urethane adhesives used in Examples and Comparative Examples are shown below.

### (a1) Aliphatic isocyanate and Alicyclic isocyanate

### (a1-1) Aliphatic isocyanate: 1,6-Diisocyanatohexane (HDI)

(manufactured by Sumika Bayer Urethane Co., Ltd. under the trade name of SUMIDULE N3300)
(HDI isocyanurate trimer (aliphatic), NCO% = 21.8%)

### (a1-2) Alicyclic isocyanate: Isophorone diisocyanate (IPDI)

(manufactured by EVONIK DEGUSSA Co., Ltd. under the trade name of VESTANATT 1890)
(IPDI isocyanurate trimer (alicyclic), NCO% = 17.3%)

### (a1-3) Aliphatic isocyanate: Xylylene diisocyanate (XDI)

(manufactured by Mitsui Chemicals, Inc. under the trade name of TAKENATE 500)
(XDI (aliphatic), NCO% = 44.7%)

### (a1') Aromatic isocyanate

### (a1'-4) 4,4'-Diphenylmethane diisocyanate (MDI)

(manufactured by Nippon Polyurethane Industry Co., Ltd under the trade name of MILLIONATE MT)
(MDI (aromatic), NCO%=33.6%)

### (a1'-5) Phenyl isocyanate (manufactured by Tokyo Chemical Industry Co., Ltd.)

(Phenyl isocyanate (aromatic), NCO = 35.3%)

### (a2) Polyol having an ester bond

### (a2-1) Polyester polyol

(Polyol component of PES229 (trade name) manufactured by Asahikawa Chemical Co., Ltd. (or Xuchuan Chemical Kunshan Company))
(Polyester polyol comprising adipic acid, isophthalic acid, phthalic anhydride, diethylene glycol, PPG400 and trimethylolpropane)

### (a2-2) Polyester polyol

(Polyol component of PES8001 (trade name) manufactured by Asahikawa Chemical Co., Ltd.)

(Polyester polyol comprising sebacic acid, terephthalic acid, hexanediol and methylpentanediol)

### (a2-3) Polyester polyol

(manufactured by Hokoku Corporation under the trade name of HS 2N-226P)
(Polyester polyol comprising phthalic anhydride and 2,4-dibutyl-1,5-pentanediol)

### (a2-4) Acrylic polyol

(manufactured by Soken Chemical & Engineering Co., Ltd. under the trade name of OG3)

(Acrylic polyol comprising n-butyl methacrylate, isobutyl methacrylate, methyl methacrylate and 2-hydroxyethyl methacrylate)

### (a2-5) Acrylic polyol

(manufactured by Estron Chemical Inc. under the trade name of ISOCRYL H270)
(Acrylic polyol comprising methyl methacrylate, butyl methacrylate, 2-hydroxyethyl methacrylate and methacrylic acid)

### (a2') Polyol having no ester bond

### (a2'-6) Polyether polyol

(manufactured by DAI-ICHI KOGYO SEIYAKU CO., LTD under the trade name of Hiflex D2000)
(PPG2000)
The urethane resin (A) according to the present invention is obtainable by reacting the component (a1) with the component (a2).

### (B) Hydroxyphenyltriazine based ultraviolet absorber

### (B1) Hydroxyphenyltriazine

(manufactured by BASF Corporation under the trade name of TINUVIN 479)
2-[4-(Octyl-2-methyl ethanoate)oxy-2-hydroxyphenyl]-4,6-[bis(2,4-dimethylphenyl)]-1,3,5-triazine

### (B2) Hydroxyphenyltriazine

(manufactured by BASF Corporation under the trade name of TINUVIN 400)
Mixture of 2-[4-(2-hydroxy-3-dodecyloxy-propyl)oxy-2-hydroxyphenyl]-4,6-[bis(2,4-dimethylphenyl)-1,3,5-triazine with 2-[4-(2-hydroxy-3-tridecyloxy-propyl)oxy-2-hydroxyphenyl]-4,6-[bis(2,4-dimethylphenyl)-1,3,5-triazine

### (B3) Hydroxyphenyltriazine

(manufactured by BASF Corporation under the trade name of TINUVIN 405)
Reaction product of 2-(2,4-dihydroxyphenyl)-4,6-bis-(2,4-dimethylphenyl)-1,3,5-triazine with (2-ethylhexyl)-glycidic ester

### (B4) Hydroxyphenyltriazine

(manufactured by BASF Corporation under the trade name of TINUVIN 460)
2,4-Bis[2-hydroxy-4-butoxyphenyl]-6-(2,4-dibutoxyphenyl)-1,3-5-triazine

### (B5) Hydroxyphenyltriazine

(manufactured by BASF Corporation under the trade name of TINUVIN 477)
Tris[2,4,6-[2-{4-(octyl-2-methyl ethanoate)oxy-2-hydroxyphenyl}]-1,3,5-triazine

### (B') Non-hydroxyphenyltriazine based ultraviolet absorber

### (B6') Benzotriazole

(manufactured by BASF Corporation under the trade name of TINUVIN 328)
2-(3,5-Di-tert-amyl-2-hydroxyphenyl)benzotriazole

### (B7') Benzotriazole

(manufactured by BASF Corporation under the trade name of TINUVIN 234)
2-[2-Hydroxy-3,5-bis(α,α-dimethylbenzyl)phenyl]-2H-benzotriazole

### (B8') Benzotriazole

(manufactured by SHUANG-BANG INDUSTRIAL CO., LTD under the trade name of SB-UVA626SP)
2-(3'-t-butyl-2'-hydroxy-5'-methylphenyl)-5-chlorobenzotriazole

### (B9') Oxalic anilide

(manufactured by Clariant (Japan) K.K. under the trade name of Hostavin PR-25)
[(4-Methoxyphenyl)-methylene]malonic acid-dimethyl ester

### (B10') Malonic ester

(manufactured by Clariant (Japan) K.K. under the trade name of Hostavin B-CAP)
Tetraethyl-2,2'-(1,4-phenylene-dimethylidyne)-bismalonate

### (C) Silane compound

### (C1) Epoxysilane

(manufactured by EVONIK DEGUSSA Co., Ltd. under the trade name of Dynasylan GLYEO)
3-Glycidoxypropyltriethoxysilane

### (C2) Epoxysilane

(manufactured by EVONIK DEGUSSA Co., Ltd. under the trade name of Dynasylan GLYMO)
3-Glycidoxypropyltrimethoxysilane

### (C3) Epoxysilane

(manufactured by CHISSO CORPORATION under the trade name of Sila-ace S530)
2-(3,4-Epoxycyclohexyl)ethyltrimethoxysilane

### (C4) Isocyanurate silane

(manufactured by Momentive Inc. under the trade name of Silquest Y-11597)
Tris(3-(trimethoxysilyl)propyl) isocyanurate

### (C5) Mercaptosilane

(manufactured by CHISSO CORPORATION under the trade name of Sila-ace S810)
3-Mercaptopropyltrimethoxysilane

### (D) Antioxidant

### (D1) Hindered phenol

(manufactured by BASF Corporation under the trade name of IRGANOX 1330)
1,3,5-Trimethyl-2,4,6-tris(3,5-di-t-butyl-4-hydroxybenzyl)benzene

### (E) Photostabilizer

### (E1) Hindered amine

(manufactured by BASF Corporation under the trade name of TINUVIN 765)
Sebacic acid bis(1,2,2,6,6-pentamethyl-4-piperidyl)
The following outdoor urethane adhesives of Examples 1 to 23 and the adhesives of Comparative Examples 1 to 9 were produced by using the above-mentioned components and then the performances of the obtained adhesives were evaluated. The production methods and evaluation methods are shown below.

### Example 1

### <Production of Outdoor Urethane Adhesive>

As shown in Table 1, after weighing and mixing:
(a1-1) SUMIDULE N3300 (trade name) manufactured by Sumika Bayer Urethane Co., Ltd. (13.16 g);
(a2-1) PES 229 (trade name) manufactured by Asahikawa Chemical Co., Ltd. (86.84 g) as a resin component,
(B1) TINUVIN 479 (trade name) manufactured by BASF Corporation (0.50 g); and
(D1) IRGANOX 1330 (trade name) manufactured by BASF Corporation (0.20 g), ethyl acetate was added to the mixture to prepare a solution having a solid content of 30%. The solution thus prepared was used as an outdoor urethane adhesive and the following tests were carried out.

### <Production of Film Laminate 1>

First, the outdoor urethane adhesive of Example 1 was applied to a transparent polyethylene terephthalate (PET) sheet (manufactured by Mitsubishi Polyester Film Corporation under the trade name of O300EW36) so that the weight of the solid component becomes 10 g/m², and then dried at 80°C for 10 minutes.
Then, a surface-treated transparent polyolefin film (linear low-density polyethylene film manufactured by Futamura Chemical Co., Ltd. under the trade name of LL-XUMN #30) was laid on the adhesive-coated surface of the PET sheet so that the treated surface contacted with the adhesive-coated surface, and then both the films were pressed using a planar press machine (manufactured by SHINTO Metal Industries Corporation under the trade name of ASF-5) under a pressing pressure of 1.0 MPa at 50°C for 30 minutes. While pressing, both films were aged at 40°C for a week to obtain a film laminate 1.

### <Production of Film Laminate 2>

The outdoor urethane adhesive of Example 1 was applied to a white PET (manufactured by Toray Industries Co., Ltd. under the trade name of Lumilar #100-E20) so that the weight of the solid component becomes 10 g/m², and then dried at 80°C for 10 minutes.
Then, a surface-treated transparent PET film (manufactured by Mitsubishi Plastics, Inc. under the trade name of TECHBARRIER V Grade) was laid on the adhesive-coated surface of the PET sheet so that the treated surface contacted with the adhesive-coated surface, and then both the films were pressed using the planar press machine under a pressing pressure of 1.0 MPa at 50°C for 30 minutes. While pressing, both films were aged at 40°C for a week to obtain a film laminate 2.

### <Evaluation>

The outdoor urethane adhesive was evaluated by the following methods.

### 1. Evaluation of Yellowness by UV Irradiation

The film laminate 1 was mounted in a UV irradiation tester (manufactured by Iwasaki Electric Co., Ltd. under the trade name of EYE Super UV Tester W13) such that the side of polyolefin film of the film laminate 1 would be the surface to be irradiated, followed by irradiation under the conditions of an illuminance of 1,000 W/m², 60°C and 50%RH for 15 hours. Color difference (Δb) was measured by a color difference meter before and after the irradiation, and then yellowness was evaluated. Evaluation criteria were as follows.
A: Δb was less than 10.
B: Δb was 10 or more and less than 15.
C: Δb was 15 or more.

### 2. Evaluation of Yellowness by Aging at High Temperature

The film laminate 2 was placed in an oven (manufactured by Shimizu Corporation under the trade name of PSFS-50) at 150°C and then allowed to stand for aging for 7 days. Color difference (Δb) was measured by a color difference meter before and after the aging, and then yellowness was evaluated. Evaluation criteria were as follows.
A: Δb was less than 13.
B: Δb was 13 or more and less than 23.
C: Δb was 23 or more.

### 3. Measurement of Peel Strength

The film laminate 1 was cut into pieces of 15 mm in width, and then a 180° peel test was performed at a tensile speed of 100 mm/min under ambient conditions using a tensile tester (manufactured by Orientec Co. under the trade name of Tensilon RTM-250). Evaluation criteria were as follows.
A: Peel strength was 8 N/15 mm or more.
B: Peel strength was 6 N/15 mm or more and less than 8 N/15 mm.
C: Peel strength was less than 6 N/15 mm.

With respect to Examples 2 to 23 and Comparative Examples 1 to 9, the respective components were blended according to the formulations shown in Tables 1 to 4 to produce adhesives in the same manner as in Example 1. The production of film laminates 1 and 2, and also the evaluation were carried out in the same manner as in Example 1.

**Table 1**

| Examples | | | | | | | | | |
|---|---|---|---|---|---|---|---|---|---|
| | | 1 | 2 | 3 | 4 | 5 | 6 | 7 | 8 |
| (a1) | (a1-1) | 13.16 | 13.50 | 13.50 | 13.50 | 13.50 | 13.50 | 13.50 | 13.50 |
| | (a1-2) | | | | | | | | |
| | (a1-3) | | | | | | | | |
| (a1') | (a1'-4) | | | | | | | | |
| | (a1'-5) | | | | | | | | |
| (a2) | (a2-1) | 86.84 | 86.50 | 86.50 | 86.50 | 86.50 | 86.50 | 86.50 | 86.50 |
| | (a2-2) | | | | | | | | |
| | (a2-3) | | | | | | | | |
| | (a2-4) | | | | | | | | |
| | (a2-5) | | | | | | | | |
| (a2') | (a2'-6) | | | | | | | | |
| Total | | 100.00 | 100.00 | 100.00 | 100.00 | 100.00 | 100.00 | 100.00 | 100.00 |
| (B) | B1 | 0.50 | 0.15 | 2.00 | 0.50 | 2.00 | 0.50 | 0.50 | 2.00 |
| | B2 | | | | | | | | |
| | B3 | | | | | | | | |
| | B4 | | | | | | | | |
| | B5 | | | | | | | | |
| (B') | B'6 | | | | | | | | |
| | B'7 | | | | | | | | |
| | B'8 | | | | | | | | |
| | B'9 | | | | | | | | |
| | B'10 | | | | | | | | |
| (C) | C1 | | | | | | | | |
| | C2 | | | | | | | | |
| | C3 | | | | | | | 0.70 | 0.70 |
| | C4 | | | | | | | | |
| | C5 | | | | | | | | |
| (D) | D1 | 0.20 | 0.10 | 0.20 | 1.00 | 1.00 | 0.20 | 0.20 | 0.20 |
| (E) | E1 | | | | | | 0.20 | 0.20 | 0.20 |
| Δb after irradiation with UV for 15 hours | | B | B | A | B | A | A | A | A |
| Δb after aging at 150°C for 7 days | | B | B | B | A | A | B | B | A |
| Peel strength | | B | B | B | B | B | B | A | A |

**Table 2**

| Examples | | | | | | | | | |
|---|---|---|---|---|---|---|---|---|---|
| | | 9 | 10 | 11 | 12 | 13 | 14 | 15 | 16 |
| (a1) | (a1-1) | 13.50 | 13.50 | 13.50 | 13.50 | 13.50 | 13.50 | 13.50 | 13.50 |
| | (a1-2) | | | | | | | | |
| | (a1-3) | | | | | | | | |
| (a1') | (a1'-4) | | | | | | | | |
| | (a1'-5) | | | | | | | | |
| (a2) | (a2-1) | 86.50 | 86.50 | 86.50 | 86.50 | 86.50 | 86.50 | 86.50 | 86.50 |
| | (a2-2) | | | | | | | | |
| | (a2-3) | | | | | | | | |
| | (a2-4) | | | | | | | | |
| | (a2-5) | | | | | | | | |
| (a2') | (a2'-6) | | | | | | | | |
| Total | | 100.00 | 100.00 | 100.00 | 100.00 | 100.00 | 100.00 | 100.00 | 100.00 |
| (B) | B1 | 0.50 | 0.50 | 0.50 | 0.50 | 0.50 | 1.00 | | |
| | B2 | | | | | | | 1.00 | |
| | B3 | | | | | | | | 1.00 |
| | B4 | | | | | | | | |
| | B5 | | | | | | | | |
| (B') | B'6 | | | | | | | | |
| | B'7 | | | | | | | | |
| | B'8 | | | | | | | | |
| | B'9 | | | | | | | | |
| | B'10 | | | | | | | | |
| (C) | C1 | | 0.7 | | | | | | |
| | C2 | | | 0.7 | | | | | |
| | C3 | 0.30 | | | | | 0.70 | 0.70 | 0.70 |
| | C4 | | | | 0.7 | | | | |
| | C5 | | | | | 0.7 | | | |
| (D) | D1 | 0.20 | 0.20 | 0.20 | 0.20 | 0.20 | 0.20 | 0.20 | 0.20 |
| (E) | E1 | 0.20 | 0.20 | 0.20 | 0.20 | 0.20 | 0.20 | 0.20 | 0.20 |
| Δb after irradiation with UV for 15 hours | | A | A | A | A | A | A | B | B |
| Δb after aging at 150°C for 7 days | | B | B | B | B | B | A | A | A |
| Peel strength | | A | A | A | A | A | A | A | A |

**Table 3**

| Examples | | | | | | | | | | |
|---|---|---|---|---|---|---|---|---|---|---|
| | | 17 | 18 | 19 | 20 | 21 | 22 | 23 | 24 | 25 |
| (a1) | (a1-1) | 13.50 | 13.50 | | | | 5.15 | 11.07 | | 3.02 |
| | (a1-2) | | | 6.75 | 30.91 | 18.08 | | | 10.94 | |
| | (a1-3) | | | 6.75 | | | 5.15 | | | 3.02 |
| (a1') | (a1'-4) | | | | | | | 7.90 | | |
| | (a1'-5) | | | | | | | | | |
| (a2) | (a2-1) | 86.50 | 86.50 | 86.50 | | | | 81.03 | | |
| | (a2-2) | | | | 69.08 | | | | 22.26 | 23.49 |
| | (a2-3) | | | | | | | | | |
| | (a2-4) | | | | | 40.96 | 44.85 | | | |
| | (a2-5) | | | | | 40.96 | 44.85 | | 66.80 | 70.47 |
| (a2') | (a2'-6) | | | | | | | | | |
| Total | | 100.00 | 100.00 | 100.00 | 100.00 | 100.00 | 100.00 | 100.00 | 100.00 | 100.00 |
| (B) | B1 | | | 1.00 | 1.00 | 1.00 | 1.00 | 1.00 | 1.00 | 1.00 |
| | B2 | | | | | | | | | |
| | B3 | | | | | | | | | |
| | B4 | 1.00 | | | | | | | | |
| | B5 | | 1.00 | | | | | | | |
| (B') | B'6 | | | | | | | | | |
| | B'7 | | | | | | | | | |
| | B'8 | | | | | | | | | |
| | B'9 | | | | | | | | | |
| | B'10 | | | | | | | | | |
| (C) | C1 | | | | | | | | | |
| | C2 | | | | | | | | | |
| | C3 | 0.70 | 0.70 | 0.70 | 0.70 | 0.70 | 0.70 | 0.70 | 0.70 | 0.70 |
| | C4 | | | | | | | | | |
| | C5 | | | | | | | | | |
| (D) | D1 | 0.20 | 0.20 | 0.20 | 0.20 | 0.20 | 0.20 | 0.20 | 0.20 | 0.20 |
| (E) | E1 | 0.20 | 0.20 | 0.20 | 0.20 | 0.20 | 0.20 | 0.20 | 0.20 | 0.20 |
| Δb after irradiation with UV for 15 hours | | B | B | B | A | A | A | B | A | A |
| Δb after aging at 150°C for 7 days | | A | A | A | A | A | A | B | A | A |
| Peel strength | | A | A | A | A | B | A | A | B | A |

**Table 4**

| Comparative Examples | | | | | | | | | | |
|---|---|---|---|---|---|---|---|---|---|---|
| | | 1 | 2 | 3 | 4 | 5 | 6 | 7 | 8 | 9 |
| (a1) | (a1-1) | 13.16 | | | 17.08 | 13.50 | 13.50 | 13.50 | 13.50 | 13.50 |
| | (a1-2) | | | | | | | | | |
| | (a1-3) | | | | | | | | | |
| (a1') | (a1'-4) | | 8.83 | | | | | | | |
| | (a1'-5) | | | 12.89 | | | | | | |
| (a2) | (a2-1) | 86.84 | 91.17 | 87.11 | | 86.50 | 86.50 | 86.50 | 86.50 | 86.50 |
| | (a2-2) | | | | | | | | | |
| | (a2-3) | | | | | | | | | |
| | (a2-4) | | | | | | | | | |
| | (a2-5) | | | | | | | | | |
| (a2') | (a2'-6) | | | | 82.92 | | | | | |
| Total | | 100.00 | 100.00 | 100.00 | 100.00 | 100.00 | 100.00 | 100.00 | 100.00 | 100.00 |
| (B) | B1 | | 0.50 | 0.50 | 0.50 | | | | | |
| | B2 | | | | | | | | | |
| | B3 | | | | | | | | | |
| | B4 | | | | | | | | | |
| | B5 | | | | | | | | | |
| (B') | B'6 | | | | | 0.50 | | | | |
| | B'7 | | | | | | 0.50 | | | |
| | B'8 | | | | | | | 0.50 | | |
| | B'9 | | | | | | | | 0.50 | |
| | B'10 | | | | | | | | | 0.50 |
| (C) | C1 | | | | | | | | | |
| | C2 | | | | | | | | | |
| | C3 | | | | | | | | | |
| | C4 | | | | | | | | | |
| | C5 | | | | | | | | | |
| (D) | D1 | | 0.20 | 0.20 | 0.20 | 0.20 | 0.20 | 0.20 | 0.20 | 0.20 |
| (E) | E1 | | | | | 0.20 | 0.20 | 0.20 | 0.20 | 0.20 |
| Δb after irradiation with UV for 15 hours | | C | C | C | C | C | C | C | C | C |
| Δb after aging at 150°C for 7 days | | C | C | C | C | B | B | B | B | B |
| Peel strength | | B | B | C | B | B | B | B | B | B |

As shown in Tables 1 to 3, the outdoor urethane adhesives of Examples 1 to 25 are excellent in peel strength, are also excellent in weatherability, and are comprehensively well-balanced as a result of containing the three of component (a1), component (a2) and component (B). Because of their excellent performance, the outdoor urethane adhesives of the Examples are suited for use as adhesives for solar battery back sheets.

Particularly, the outdoor urethane adhesives of Examples 8, 14, 20, 22 and 25 are excellent in peel strength and cause little change in color difference, and are also extremely excellent in weatherability and, therefore, these outdoor urethane adhesives are each well suited for use as an adhesive for back sheets of an organic (dye-sensitized) solar battery.

On the other hand, the outdoor urethane adhesives of Comparative Examples 1 to 9 shown in Table 4 do not contain any one of the three components of the component (a1), the component (a2) and the component (B). Because of lack of any one of these three components, the outdoor urethane adhesives of Comparative Examples are inferior in performance of peel strength or weatherability as compared with Examples.

These results revealed that it is important for an outdoor urethane adhesive to contain, as essential components, a urethane resin (A) obtained by reacting a component (a1) with a component (a2), and a component (B).

### Industrial Applicability

The present invention provides an outdoor urethane adhesive. The outdoor urethane adhesive according to the present invention is used in outdoor materials such as barrier materials, roof materials, solar battery modules, window materials, outdoor flooring materials, illumination protective materials, automobile members and signboards, and is particularly suited for the production of a solar battery back sheet.

### Related Application

This application claims priority under Article 4 of the Paris Convention based on Japanese Patent Application No. 2010-265365 filed on November 29, 2010, the entire content of which is incorporated herein by reference.

### Description of Reference Numerals

- 1:: Solar battery module
- 10:: Backsheet
- 11:: Film
- 11a:: Deposited thin film
- 12:: Film
- 13:: Adhesive layer
- 20:: Sealing material (EVA)
- 30:: Solar battery cell
- 40:: Glass plate
- 50:: Spacer

## Claims

1. An outdoor urethane adhesive, comprising
(A) a urethane resin obtainable by reacting an isocyanate compound (a1) and a polyol having an ester bond (a2), and
(B) a hydroxyphenyltriazine based compound,
wherein the isocyanate compound (a1) comprises at least one selected from aliphatic isocyanates and alicyclic isocyanates.

2. The outdoor urethane adhesive according to claim 1, wherein the polyol (a2) comprises at least one selected from a polyester polyol and an acrylic polyol.

3. The outdoor urethane adhesive according to claim 1 or claim 2, wherein the adhesive further comprises a silane compound.

4. The outdoor urethane adhesive according to claim 3, wherein said silane compound is selected from the group consisting of (meth)acryloxyalkyltrialkoxysilanes, (meth)acryloxyalkylalkylalkoxysilanes, vinyltrialkoxysilanes, vinylalkylalkoxysilanes, epoxysilanes, mercaptosilanes and isocyanuratesilanes.

5. The outdoor urethane adhesive according to claim 4, wherein said silane compound is an epoxysilane.

6. The outdoor urethane adhesive according to any one of claims 1 to 5 further comprising a hindered phenol compound.

7. The outdoor urethane adhesive according to any one of claims 1 to 6 further comprising a hindered amine based compound.

8. A solar battery back sheet obtainable by using the outdoor urethane adhesive according to any one of claims 1 to 7.

9. A solar battery module obtainable by using the solar battery back sheet according to claim 8.
